# EUROPÄISCHE PATENTANMELDUNG

(11) **EP 0 734 198 A2**
(43) Veröffentlichungstag der Anmeldung: **25.09.1996**
(21) Anmeldenummer: 96104199.3
(22) Anmeldetag: 16.03.1996
(51) Int. Cl.: H05K 7/20, H02K 9/00, D06F 37/30

(54) **Kühleinrichtung für elektronische Bauteile**

(30) Priorität: 24.03.1995 DE 19510774
(71) Anmelder: HANNING ELEKTRO-WERKE GMBH & CO., D-33813 Oerlinghausen (DE)
(72) Erfinder: König, Klaus, 33813 Oerlinghausen (DE)
(74) Vertreter: TER MEER - MÜLLER - STEINMEISTER & PARTNER

(57) **Zusammenfassung**

Eine Kühleinrichtung für elektronische Bauteile, insbesondere für Umrichter für frequenzgesteuerte Motoren in Waschmaschinen, umfaßt eine die elektronischen Bauteile aufnehmende Grundplatte aus Metall oder einem anderem guten Wärmeleiter. Angrenzend an die Grundplatte (22) ist ein Kühlwasserspeicher (28,32,34) ausgebildet, der von wenigstens einem Teil des von der Waschmaschine aufgenommenen Frischwassers durchströmt wird.

## Beschreibung

Die Erfindung betrifft eine Kühleinrichtung für elektronische Bauteile, insbesondere für Umrichter für frequenzgesteuerte Motoren in Waschmaschinen, mit einer die elektronischen Bauteile aufnehmenden Grundplatte aus Metall oder einem anderen guten Wärmeleiter.

Für den Antrieb von Waschmaschinentrommeln von gewerblichen und privaten Waschmaschinen werden wegen der verhältnismäßig einfachen Regelbarkeit, der relativ günstigen Herstellkosten und einiger weiterer Vorteile zinnehmend frequenzgesteuerte Elektromotoren eingesetzt. Derartige Motoren, die die Trommel in den Betriebszuständen Waschen, Anlegen, Schleudern und Trocknen zumeist mit unterschiedlicher Drehzahl drehen, erfordern einen Frequenzumrichter, der angesichts der nicht unbeträchtlichen Leistungsaufnahme der Motoren eine nicht unerhebliche Abwärme erzeugt. Diese Abwärme wird zumeist in der Weise abgeführt, daß die elektronischen Bauteile des Umrichters auf einer metallischen Platte angebracht werden, an deren Rückseite ein mit zahlreichen Kühlrippen versehener Kühlkörper angebracht ist. Dieser Kühlkörper muß aus der Rückseite der Waschmaschine herausragen, damit er genügend mit Außenluft in Berührung kommt. Wegen seiner oft erheblichen Abmessungen ist dies ein Nachteil, insbesondere dann, wenn die Kühlrippen über ein bestimmtes Maß über den MaschinengehäuseUmriß hinausragen und damit die Verpackung und den Transport erschweren, ein Verletzungsrisiko darstellen etc. Im übrigen verstauben die Rippen rasch, so daß die Wärmeabgabe in schwer vorhersehbarer Weise abnimmt.

Zusätzliche Schwierigkeiten ergeben sich, wenn es erforderlich ist, die elektronischen Bauteile oberhalb der Maschinentrommel unterhalb dem oberen Deckel der Maschine anzuordnen, wie es zumeist aus Gründen der bequemen Zugänglichkeit bei der Wartung gefordert wird. In diesem oberen Bereich der Maschine sammelt sich die gesamte, aufsteigende Abwärme der Motoren der Maschine und insbesondere der durch warmes Waschwasser ständig aufgeheizten Trommel. Unterhalb des Maschinendeckels können daher Temperaturen von 60 bis 70°C erreicht werden. Dies sind aber die Temperaturen, bei denen die meisten in Betracht kommenden elektronischen Bauteile, insbesondere die verwendeten Kondensatoren, bereits in ihrer Lebensdauer eingeschränkt werden und im übrigen ihrerseits weitere Wärme abgeben, so daß der Maschinenbetrieb üblicherweise mit Hilfe von am Umrichter angebrachten Temperaturfühlern abgeschaltet wird. Die Verwendung von wärmebeständigeren, teureren elektronischen Bauteilen stellt zumeist aus wirtschaftlichen Gründen keine in Betracht kommende Alternative dar.

Der Erfindung liegt daher die Aufgabe zugrunde, eine Kühleinrichtung der gattungsgemäßen Art zu schaffen, die es in verhältnismäßig einfacher Weise ermöglicht, elektronische Bauteile, insbesondere Umrichter, für Waschmaschinen-Antriebsmotoren auch in einer aufgeheizten Umgebung auf einer angemessenen Betriebstemperatur zu halten.

Diese Aufgabe wird erfindungsgemäß dadurch gelöst, daß angrenzend an die Grundplatte ein Kühlwasserspeicher ausgebildet ist, der von wenigstens einem Teil des von der Waschmaschine aufgenommenen Frischwassers durchströmt wird.

Erfindungsgemäß ist also eine Wasserkühlung vorgesehen, die kein eigenes Kühlwasser und auch keine eigene Kühlwassersteuerung erfordert, sondern das ohnehin der Maschine für den Waschvorgang zugeführte Frischwasser verwendet.

Es ist zwar auf dem Gebiet von Umwälzpumpen von Warmwasserheizungen aus verschiedenen Druckschriften, beispielsweise den deutschen Patenten 41 21 430, 42 22 394 und 43 27 735, bekannt gewesen, das gepumpte Medium selbst, also das Wasser der Heizungsanlage, zur Kühlung des Pumpenmotors und gegebenenfalls auch eines Frequenzumrichters einzusetzen. Dabei konnte jedoch im Durchlaufverfahren gekühlt werden, da Umwälzpumpen von Heizungsanlagen kontinuierlich oder zumeist über längere Perioden in Betrieb sind. Im übrigen stand das Kühlmedium Wasser unmittelbar aufgrund des Pumpenbetriebs zur Verfügung. Bei frequenzgesteuerten Motoren in Waschmaschinen, also zumeist in Antriebsmotoren der Trommel, entfällt die Voraussetzung eines kontinuierlich durch den Motor selbst geförderten Stromes eines zur Kühlung geeigneten Mediums. In Waschmaschinen sind zwar auch Pumpen vorgesehen, jedoch werden diese zumeist nur zum Auspumpen der Maschine nach den einzelnen Waschvorgängen eingesetzt, so daß das gepumpte Kühlmedium erst nach Abschluß des Waschvorganges zur Verfügung stehen würde und im übrigen wegen seiner Temperatur von bis zu 95° C zur Kühlung ungeeignet wäre.

Erfindungsgemäß wird daher das von der Maschine selbst aus der Wasserleitung aufgenommene, mit dem Leitungsdruck zugeführte Wasser als Kühlwasser verwendet.

Ein weiterer Unterschied gegenüber den erwähnten, bekannten Kühlsystemen für Heizungs-Umwälzpumpen besteht darin, daß das erfindungsgemäß verwendete Kühlmedium Frischwasser nur bei Beginn des Waschvorganges oder der verschiedenen Wasch- und Spülvorgänge, d.h., zumindest jeweils nur zur Beginn des einzelnen Arbeitsgangs zur Verfügung steht. Das Wasser kann daher nicht im Durchlauf eingesetzt werden, sondern muß in einer ausreichenden Menge in einem Speicher aufgenommen werden, dessen Kühlkapazität für den jeweils anschließenden Arbeitsgang ausreicht.

Vorzugsweise befindet sich der Kühlwasserspeicher in einem Kunststoffgehäuse, das durch die Grundplatte der elektronischen Bauteile in eine erste Kammer, die den Kühlwasserspeicher bildet, und eine zweite Kammer, in der sich die auf der Grundplatte befestigten elektronischen Bauteile befinden, unterteilt wird. Diese zweite Kammer ist vorzugsweise einseitig offen und nur durch eine mit Lüftungsöffnungen versehene dünne Platte abgedeckt, die beispielsweise auch die Rückwand der Maschine sein kann.

Wenn der Wärmeübergang zwischen der Grundplatte und dem Kühlwasser in dem Kühlwasserspeicher nicht ausreicht, kann die Grundplatte mit Kühlrippen versehen sein, die in dem Kühlwasser liegen.

In der Regel wird sich innerhalb des Kühlwasserspeichers durch Aufsteigen des erwärmten Wassers eine gewisse Zirkulation ausbilden, die einen ständigen Wärmeausgleich herbeiführt. Das Wasser wird im übrigen auch durch die ständigen, unvermeidlichen Vibrationen der Waschmaschine in Bewegung gehalten.

Weitere Einzelheiten der Erfindung ergeben sich aus den Unteransprüchen.

Im folgenden werden bevorzugte Ausführungsbeispiele der Erfindung anhand der beigefügten Zeichnungen näher erläutert.

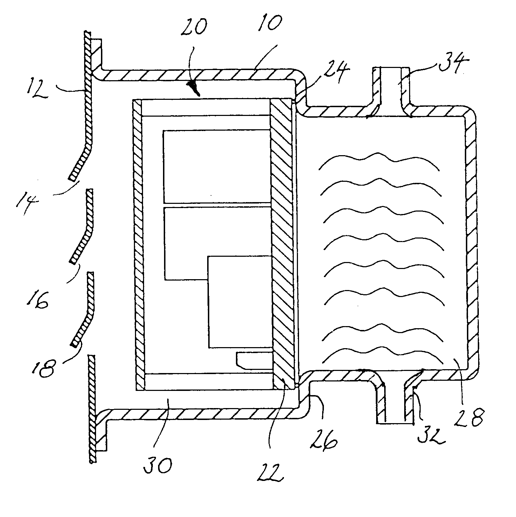

Die einzige Figur ist ein schematischer senkrechter Schnitt durch eine erfindungsgemäße Kühleinrichtung.

Die Kühleinrichtung weist als Grundbestandteil ein Gehäuse 10, beispielsweise aus Kunststoff, auf. Das dargestellte Gehäuse 10 kann im weitesten Sinne als kastenförmig bezeichnet werden. Es ist auf der linken Seite in der Zeichnung offen und hier durch eine dünne Platte 12, etwa eine Blechplatte, verschlossen, die Lüftungsschlitze 14,16,18 aufweist. Diese Blechplatte kann beispielsweise die Rückwand der Waschmaschine sein, d.h., das Gehäuse 10 kann unmittelbar auf der Innenseite der Rückwand angebracht sein.

Im Inneren des Gehäuses 10 befindet sich auf der linken Seite der Zeichnung ein Frequenzumrichter 20 mit einer Anzahl von nicht im einzelnen bezeichneten, elektronischen Bauteilen, die auf einer Grundplatte 22 befestigt sind. Diese Grundplatte 22 liegt über eine Dichtung, die schematisch als O-Ring 24 dargestellt ist, gegen eine Stufe 26 an, über die sich das Gehäuse 10 von links nach rechts in der Zeichnung verjüngt. Die Grundplatte 22 unterteilt daher gewissermaßen das Gehäuse 10 in zwei Kammern, von denen die rechts in der Zeichnung liegende Kammer 28 als erste Kammer und deren zweite, links in der Zeichnung liegende, erweiterte Kammer 30 als zweite Kammer bezeichnet werden soll. Die erste Kammer 28 ist mit Kühlwasser gefüllt. Sie besitzt einen Einlaß 32 und einen Auslaß 34 und ist in den Frischwasserstrom integriert der vom Leitungsnetz über ein nicht dargestelltes Magnetventil zunächst in den Spülkasten der Waschmaschine und damit letztlich in die Trommel der Waschmaschine mündet. Das gesamte zugeführte Frischwasser für die einzelnen Waschgänge durchströmt damit die Kammer 28. Die Steuerung erfolgt mit dem ohnehin für die Füllung der Waschmaschine vorgesehenen Magnetventil. Zusätzliche Ventile und Steuerungen sind nicht notwendig. Der Leitungsaufwand ist gering, da die ohnehin vorhandene Verbindung zwischen dem Leitungsnetz, dem Magnetventil, dem Spülkasten und der Waschmaschine lediglich über die Kammer 28 geführt werden muß.

Naturgemäß ist es auch möglich, den Wasserstrom zu teilen, die Kammer 28 also nur über einen Bypass mit Leitungswasser zu versorgen.

In jedem Falle ist es vorteilhaft, die Kühleinrichtung mit der Kammer 28 stromabwärts des Magnetventils anzuordnen, so daß die Kammer 28 stets im wesentlichen drucklos ist.

Die Größe der Kammer 28 muß so bemessen sein, daß die Kühlkapazität des in der Kammer 28 enthaltenen Wassers zur Kühlung der Grundplatte 22 und damit der elektronischen Bauteile auf eine geeignete Betriebstemperatur ausreicht.

Aufgrund der Lüftungsöffnungen 14,16,18 besteht im übrigen ein Luftaustausch und damit eine zusätzliche Kühlmöglichkeit des Umrichters 20.

## Patentansprüche

1. Kühleinrichtung für elektronische Bauteile, insbesondere für Umrichter für frequenzgesteuerte Motoren in Waschmaschinen, mit einer die elektronischen Bauteile aufnehmenden Grundplatte aus Metall oder einem anderem guten Wärmeleiter, dadurch **gekennzeichnet**, daß angrenzend an die Grundplatte (22) ein Kühlwasserspeicher (28,32,34) ausgebildet ist, der von wenigstens einem Teil des von der Waschmaschine aufgenommenen Frischwassers durchströmt wird.

2. Kühleinrichtung nach Anspruch 1, dadurch **gekennzeichnet**, daß die Kühleinrichtung ein Gehäuse (10), insbesondere aus Kunststoff, umfaßt, dessen Inneres durch die Grundplatte (22) des Umrichters (20) in zwei Kammern (28,30) unterteilt ist, deren erste (28) den Kühlwasserspeicher bildet und deren zweite (30) die auf der Grundplatte (22) befestigten Elemente des Umrichters (20) aufnimmt.

3. Kühleinrichtung nach Anspruch 2, dadurch **gekennzeichnet**, daß das Gehäuse (10) im Bereich der zweiten, die elektronischen Bauteile des Umrichters (20) aufnehmenden Kammer (30) einseitig offen und durch eine mit Lüftungsöffnungen (14,16,18) versehene Platte (12) verschlossen ist.

4. Kühleinrichtung nach Anspruch 2 oder 3, dadurch **gekennzeichnet**, daß das Gehäuse (10) am Übergang von der ersten zur zweiten Kammer (28,30) stufenförmig nach außen erweitert ist und daß die Grundplatte (22) des Umrichters (20) gegen die auf diese Weise gebildete Stufe (26) anliegt.

5. Kühleinrichtung nach einem der vorgehenden Ansprüche, dadurch **gekennzeichnet**, daß auf der Grundplatte (22) auf der dem Kühlwasserspeicher zugewandten Seite Kühlrippen ausgebildet sind.

6. Kühleinrichtung nach Anspruch 3, dadurch **gekennzeichnet**, daß die Platte (12) eine gute Wärmeleitfähigkeit aufweist.

7. Kühleinrichtung nach einem der Ansprüche 3 bis 6, dadurch **gekennzeichnet**, daß die Platte (12) auf der Innen- und Außenfläche eine die Oberfläche vergrößernde Profilierung, insbesondere Rippen oder Wellen, aufweist.
